# EUROPEAN PATENT APPLICATION

(11) **EP 4 053 310 A1**
(43) Date of publication of application: **07.09.2022**
(21) Application number: 20882647.9
(22) Date of filing: 14.09.2020
(51) Int. Cl.: C30B 29/16, C30B 15/34

(54) **SINGLE CRYSTAL INGOT, CRYSTAL GROWTH DIE, AND SINGLE CRYSTAL PRODUCTION METHOD**

(30) Priority: 28.10.2019 JP 2019195191
(71) Applicant: AGC Inc., Tokyo 100-8405 (JP)
(72) Inventor: KUMAGAI, Hirohiko, Tokyo 100-8405 (JP); YAMAOKA, Yu, Sayama-Shi, Saitama 350-1328 (JP)
(74) Representative: Müller-Boré & Partner Patentanwälte PartG mbB
(86) International application number: PCT/JP2020/034653
(87) International publication number: WO 2021/084941

(57) **Abstract**

An as-grown single crystal ingot 1 of a dopant-containing metal oxide or quasi-binary compound is provided in which a lateral surface 221 has a length L greater than or equal to 50 mm, there is a linear recess 222 on the lateral surface 221, and, in the area surrounded by the lateral surface 221, the outer shape of the cross-section perpendicular to the length direction and positioned spaced 50 mm away in the length direction from the other end in the length direction without with the recess 222 is such that, outside of the area formed by the line of intersection between the cross-section and a faceted surface, the maximum value of the distance X of the recess 222 from an ideal outer shape 30 is less than or equal to 5 mm.

## Description

### TECHNICAL FIELD

The present invention relates to a single crystal ingot, a crystal growth die, and a manufacturing method of a single crystal.

### BACKGROUND ART

The EFG (Edge-defined Film-fed Growth) method (refer to Patent document 1, for example) is known as a conventional single crystal growing method. Patent document 1 discloses a method for growing a flat plate-shaped β-Ga₂O₃ single crystal by the EFG method.

The EFG method is a technique of growing a flat plate-shaped single crystal by immersing a lower portion of a die formed with a slit in a melt, holding, on the die, a melt that has risen up through the slit due to capillary phenomenon, bringing a seed crystal into contact with the melt thus risen up, and pulling up a resulting single crystal. Usually, a cross section, taken perpendicularly to the crystal pulling direction, of a single crystal thus pulled up is approximately the same, in shape, as the top surface of the die.

### CITATION LIST

### PATENT LITERATURE

Patent document 1: JP-A-2004-56098

### SUMMARY OF INVENTION

### TECHNICAL PROBLEM

However, the present inventors carried out EFG crystal growth repeatedly by adding various dopants to a Ga₂O₃ material to control resistivity and found that single crystals grown have following problems (deficit) described below depending on the kind of dopant added.

In crystal growth from an undoped Ga₂O₃ material, a resulting crystal expanded until coming very close to edges of the top surface of the die and, as mentioned above, a cross section, taken perpendicularly to the crystal pulling direction, of the pulled-up single crystal was approximately the same, in shape, as the top surface of the die. On the other hand, if EFG crystal growth was carried out by adding FeO to a material to make a resulting Ga₂O₃ single crystal semi-insulative, there was a tendency that a crystal being grown did not expand easily toward the edges of the die top surface. As a result, plural linear recesses extending in the pulling direction were formed on an as-grown surface extending in the crystal pulling direction of a single crystal being pulled up. These recesses extended as the pulling-up operation proceeded.

If such recesses are formed in a single crystal grown, an area from which substrates can be cut out is reduced when substrates having a desired shape are cut out from the single crystal. This results in reduction in the yield of substrate manufacture.

For solving the above described problems, an object of the present invention is to provide an EFG manufacturing method of a single crystal capable of decreasing the depths of the recesses even in a case that recesses are formed on an as-grown surface, extending in a crystal pulling direction, of a single crystal grown, a crystal growth die to be used in that manufacturing method, and a single crystal ingot manufactured by that manufacturing method.

### SOLUTION TO PROBLEM

To attain the above object, one aspect of the invention provides the following single crystal ingots of items [1] to [5], crystal growth dies of items [6] to [11], and manufacturing methods of a single crystal of items [12] to [15]:
[1] An as-grown single crystal ingot of a metal oxide containing a dopant or a pseudobinary-component compound, in which:
   a length of a side surface, extending in a longitudinal direction that is parallel with a crystal pulling direction, in the longitudinal direction is 50 mm or larger;
   the side surface has a linear recess that extends in the longitudinal direction from one end in the longitudinal direction;
   among cross sections taken perpendicularly to the longitudinal direction of a portion surrounded by the side surface, a cross section at a position that is distant from the other end located on a side without the recess in the longitudinal direction by 50 mm in the longitudinal direction has an external shape such that a distance Xₘₐₓ that is a maximum value of distance of the recess from an ideal external shape is 5 mm or shorter in portions excluding a portion formed by an intersection line of the cross section and a facet; and
   the ideal external shape is a rectangle or a quadrangle having a smallest area capable of containing the external shape of the cross section.
[2] The single crystal ingot according to [1], in which a width of the single crystal ingot is 50 mm or larger.
[3] The single crystal ingot according to item [1] or [2], in which the distance Xₘₐₓ that is a maximum value of distance of the recess from the ideal external shape is 5 mm or shorter in all portions including the portion formed by the intersection line of the cross section and the facet.
[4] The single crystal ingot according to any one of items [1] to [3], in which:
   the metal oxide is a Ga₂O₃-based semiconductor; and
   the dopant is one or more elements selected from the group consisting of Mg, Si, Ti, Fe, Co, Ni, Cu, Zr, Nb, Hf, and Ta.
[5] The single crystal ingot according to any one of items [1] to [4], in which the distance Xₘₐₓ is 1 mm or longer.
[6] A crystal growth die to be used for crystal growth using an EFG method, the crystal growth die including:
   a top surface having an opening of a slit and being flat; and
   a drainage acceleration portion for urging drainage of a melt from the top surface, that is formed at an edge of the top surface or a position that is located in a vicinity of the edge and spaced from the slit.
[7] The crystal growth die according to item [6], in which the drainage acceleration portion is formed at least in a vicinity of the edge that is parallel with the slit.
[8] The crystal growth die according to item [6] or [7], in which the drainage acceleration portion is a chamfered portion, an R-chamfered portion, or a step portion that is formed in at least a part of the edge.
[9] The crystal growth die according to item [6] or [7], in which the drainage acceleration portion is a slant portion that is formed in entire or a part of an upper portion of a side surface.
[10] The crystal growth die according to item [6] or [7], in which the drainage acceleration portion is a groove that is formed in a side surface so as to extend downward from the top surface.
[11] The crystal growth die according to item [6] or [7], in which the drainage acceleration portion is a through-hole having an opening in a region located in a vicinity of the edge of the top surface.
[12] A manufacturing method, using an EFG method, of a single crystal of a metal oxide containing a dopant or a pseudobinary-component compound, in which:
   the single crystal is pulled up while a melt located between a top surface of a crystal growth die and a single crystal growth interface is drained from an edge of the top surface of the crystal growth die or a portion in a vicinity of the edge.
[13] A manufacturing method, using an EFG method, of a single crystal of a metal oxide containing a dopant or a pseudobinary-component compound, in which:
   a linear recess is formed in a side surface extending in a longitudinal direction that is parallel with a crystal pulling direction of the single crystal when the single crystal is pulled up; and
   in an ingot of the single crystal grown, among cross sections taken perpendicularly to the longitudinal direction of a portion surrounded by the side surface, a cross section at a position that is distant from an end located on a side without the recess in the longitudinal direction by 50 mm in the longitudinal direction has an area of 80% or more of an area of the top surface of a crystal growth die.
[14] The manufacturing method of a single crystal according to item [12] or [13], in which:
   the metal oxide is a Ga₂O₃-based semiconductor; and
   the dopant is one or more elements selected from the group consisting of Mg, Si, Ti, Fe, Co, Ni, Cu, Zr, Nb, Hf, and Ta.
[15] The manufacturing method of a single crystal according to any one of claims 12 to 14, in which the crystal growth die according to any one of claims 6 to 11 is used.

### ADVANTAGEOUS EFFECTS OF INVENTION

The present invention can provide an EFG manufacturing method of a single crystal capable of decreasing the depths of the recesses even in a case that a dopant is added that causes recesses to be formed on an as-grown surface, extending in a pulling direction, of a single crystal grown, a crystal growth die to be used in that manufacturing method, and a single crystal ingot manufactured by that manufacturing method.

### BRIEF DESCRIPTION OF DRAWINGS

[FIG. 1] FIG. 1 is vertical sectional view of part of an EFG single crystal growing apparatus according to a first embodiment of the present invention.
[FIG. 2A] FIG. 2A is a schematic diagram showing a state in the vicinity of a crystal growth interface in EFG single crystal growth using a conventional apparatus.
[FIG. 2B] FIG. 2B is a schematic diagram showing a state in the vicinity of a crystal growth interface in EFG single crystal growth using a conventional apparatus.
[FIG. 3A] FIG. 3A is a phase diagram showing a relationship between the temperature of a certain pure substance and the concentration of a dopant added to that pure substance.
[FIG. 3B] FIG. 3B is another phase diagram showing a relationship between the temperature of the certain pure substance and the concentration of a dopant added to that pure substance.
[FIG. 4A] FIG. 4A shows an appearance of a single crystal ingot grown by an EFG method using a conventional apparatus, as comparative example.
[FIG. 4B] FIG. 4B is a sectional view, taken perpendicularly to the crystal pulling direction, of the single crystal ingot shown in FIG. 4A.
[FIG. 5] FIG. 5 is a schematic diagram showing a state in the vicinity of a crystal growth interface in EFG single crystal growth using a crystal growth die of the first embodiment of the invention.
[FIG. 6A] FIG. 6A is a sectional view of part of an EFG single crystal growing apparatus that employs a modification of the crystal growth die.
[FIG. 6B] FIG. 6B is a sectional view of part of an EFG single crystal growing apparatus that employs another modification of the crystal growth die.
[FIG. 7A] FIG. 7A is a perspective view showing an example structure of drainage acceleration portions of the crystal growth die of the first embodiment of the invention.
[FIG. 7B] FIG. 7B is a perspective view showing an example structure of drainage acceleration portions of the crystal growth die of the first embodiment of the invention.
[FIG. 7C] FIG. 7C is a perspective view showing an example structure of drainage acceleration portions of the crystal growth die of the first embodiment of the invention.
[FIG. 8] FIG. 8 is a perspective view of a crystal growth die of a case that portions of the edges of the top surface are formed with chamfered portions, respectively.
[FIG. 9A] FIG. 9A is a perspective view showing an example structure of drainage acceleration portions of the crystal growth die of the first embodiment of the invention.
[FIG. 9B] FIG. 9B is a perspective view showing an example structure of drainage acceleration portions of the crystal growth die of the first embodiment of the invention.
[FIG. 9C] FIG. 9C is a perspective view showing an example structure of drainage acceleration portions of the crystal growth die of the first embodiment of the invention.
[FIG. 10] FIG. 10 is a perspective view of a crystal growth die in which all of the edges of the top surface are formed with chamfered portions, respectively.
[FIG. 11A] FIG. 11A shows an appearance of a single crystal ingot of the first embodiment of the invention.
[FIG. 11B] FIG. 11B is an example cross section, taken perpendicularly to the longitudinal direction at a position that is distant by 50 mm from an end located on the side without recesses in the longitudinal direction, of a portion, surrounded by a side surface, of a single crystal ingot.
[FIG. 11C] FIG. 11C is another example cross section, taken perpendicularly to the longitudinal direction at a position that is distant by 50 mm from an end located on the side without recesses in the longitudinal direction, of a portion, surrounded by a side surface, of a single crystal ingot.
[FIG. 12] FIG. 12 is a phase diagram showing a relationship between the temperature and the composition of a composite oxide including an AO component and a BO component.
[FIG. 13] FIG. 13 is a plan view showing a plate member measuring 25 mm × 15 mm that was cut out from a Ga₂O₃ single crystal ingot by cutting it perpendicularly to a crystal pulling direction and measurement positions of a concentration measurement.
[FIG. 14A] FIG. 14A is a graph showing a distribution of Fe concentration in the Ga₂O₃ single crystal plate member measured.
[FIG. 14B] FIG. 14B is another graph showing a distribution of Fe concentration in the Ga₂O₃ single crystal plate member measured.

### DESCRIPTION OF EMBODIMENTS

### [First Embodiment]

Although the present embodiment will be described mainly using a single crystal of a Ga₂O₃-based semiconductor as an example metal oxide single crystal grown, the metal oxide single crystal of the present invention is not limited to it.

### (Configuration of EFG single crystal growing apparatus)

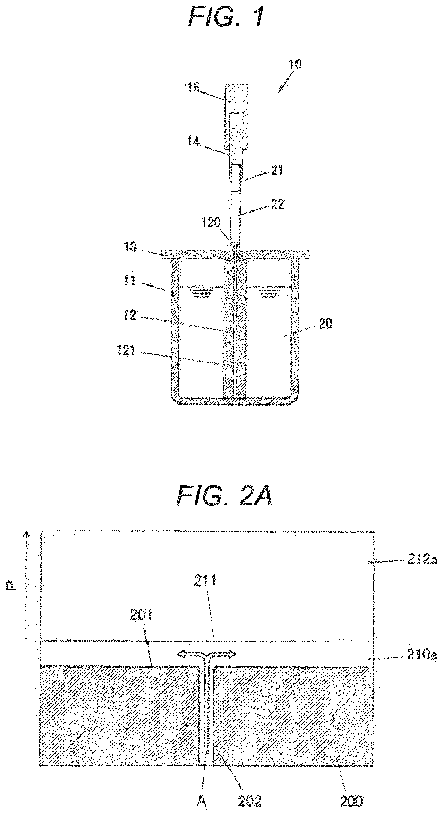

FIG. 1 is vertical sectional view of part of an EFG single crystal growing apparatus 10 according to a first embodiment of the invention.

The EFG single crystal growing apparatus 10 includes a crucible 11 which contains a melt 20 of a Ga₂O₃-based compound and a dopant(s) such as FeO; a crystal growth die 12 which is set in the crucible 11; a lid 13 which closes the opening of the crucible 11 so that a top surface 120 of the crystal growth die 12 is exposed; a seed crystal holding member 14 which holds a flat plate-shaped seed crystal 21 that is a single crystal of the Ga₂O₃-based compound; and a shaft 15 which supports the seed crystal holding member 14 in such a manner as to elevate and lower it.

The crucible 11 contains the melt 20 that was obtained by melting a sintered body of powder, granules, pellets, etc. of the Ga₂O₃-based compound. The crucible 11 is made of a material such as iridium that is so heat-resistant as to be able to contain a melt 20 of the Ga₂O₃-based compound.

The crystal growth die 12 has a slit 121 for elevating a melt 20 in the crucible 11 to the top surface 120 by capillary phenomenon. The crystal growth die 12 has, as a novel and an unprecedented structure, drainage acceleration portion for accelerating drainage, from the top surface 120, of melts 20 in the vicinities of the edges of the top surface 120. The drainage acceleration portions will be described later.

The lid 13 prevents evaporation of the high-temperature melt 20 from the crucible 11 and also prevents solidified material in which vapor of the melt 20 is condensed from sticking to portions, other than the top surface 120, of the crystal growth die 12.

The EFG single crystal growing apparatus 10 grows a flat plate-shaped growth crystal 22 by lowering the seed crystal 21 so as to bring it into contact with the top surface 120 of the crystal growth die 12 that is supplied with the melt 20 and pulling up the seed crystal 21 that have been kept in contact with the melt 20. The crystal orientation of the growth crystal 22 is the same as that of the seed crystal 21, and the crystal orientation of the growth crystal 22 is controlled by, for example, adjusting the surface orientation and the angle in the horizontal plane of the bottom surface of the seed crystal 21.

Each of the seed crystal 21 and the growth crystal 22 are a single crystal of a Ga₂O₃-based compound. The Ga₂O₃-based compound is Ga₂O₃ or Ga₂O₃ added with elements such as Al and In and has, for example, a composition represented by (InₓAl_{y}Ga_{z})₂O₃ (x + y + z = 1, x ≥ 0, y ≥ 0, and z > 0). Furthermore, the Ga₂O₃-based compound constituting the seed crystal 21 and the growth crystal 22 or the Ga₂O₃-based compound constituting the growth crystal 22 contains, as a dopant(s), an element that is low in volatility in the vicinity of a melting temperature of Ga₂O₃, such as Mg, Si, Ti, Fe, Co., Ni, Cu, Zr, Nb, Hf, or Ta. The dopant will be described later.

### (Problem of single crystal growth by EFG method)

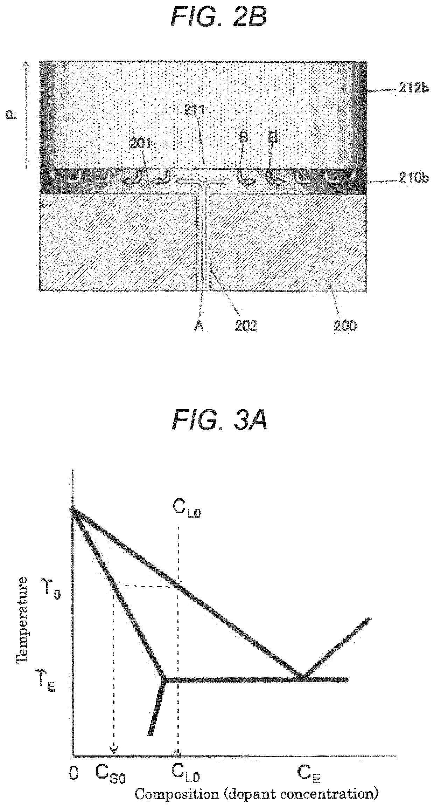

FIGs. 2A and 2B are schematic diagrams each showing a state in the vicinity of a crystal growth interface of EFG single crystal growth using a conventional apparatus. FIG. 2A is a schematic diagram of a case that a growth crystal 212a containing no dopant is grown from a melt 210a containing no dopant. FIG. 2B is a schematic diagram of a case that a growth crystal 212b containing a dopant is grown from a melt 210b containing the dopant.

A problem of the single crystal growth by the EFG method that has been found by the present inventors will be described with reference to FIGs. 2A and 2B.

As shown in FIGs. 2A and 2B, in the EFG method, the volume of a melt 210 that is directly involved in the crystal growth is restricted to that of a gap between a crystal growth surface 211 and the top surface 201 of a crystal growth die 200 and a melt 210a or 210b is supplied continuously from a slit 202 of the crystal growth die 200 to the gap. Arrow A in FIGs. 2A and 2B indicates a flow of the melt 210a or 210b and arrow P indicates a crystal pulling direction.

In the melt 210b, the dopant exists in the form of an oxide (e.g., Fe exists in a Ga₂O₃ melt in the form of FeO or the like). Thus, when a growth crystal 212b is grown, as shown in FIG. 2B the concentration of the dopant oxide increases in portions of a melt 210b that are distant from the slit 202 in the gap due to segregation. In FIG. 2B, the gradation that is given to each of the melt 210b and the growth crystal 212b indicates, schematically, a concentration distribution of the dopant oxide; a darker gradation portion means a higher concentration. Arrows B in FIG. 2B indicate flows of a dopant oxide that remains in the melt 210b without being incorporated into the growth crystal 212b. Since the solidification temperature of the melt 210b lowers as the concentration of the dopant oxide increases, crystal growth from portions distant from the slit 202 lowers.

As a result, growth failures occur in the vicinities of outer peripheries of a growth crystal 212b and plural linear recesses extending in the crystal pulling direction P are formed in a side surface (as-grown surface) extending in the crystal pulling direction P. On the other hand, where a growth crystal 212a containing no dopant is grown, as shown in FIG. 2A, since no dopant is contained in the melt 210a, a melt 210a in the gap between the crystal growth surface 211 and the top surface 201 of the crystal growth die 200 is uniform. As a result, the growth crystal 212a is not formed with linear recesses due to segregation of a dopant oxide in the melt.

Although segregation of a dopant in a material also occurs in crystal growth from a melt in the Czochralski method, Bridgman method, Kyropoulos method, heat exchange method (HEM), etc., since the volume of a melt involved in crystal growth is not small unlike in the EFG method, there does not occur a phenomenon that recesses are formed in the surface of a growth crystal because crystal growth is obstructed by segregation of a dopant oxide.

The present inventors have studied, from the viewpoint of the crystal growth engineering, about a specific mechanism of how recesses are formed in growing a Ga₂O₃ single crystal to which Fe is added as a dopant, and have made the following analyses and judgments.

(1) Ga₂O₃ is doped with Fe by adding a doping material that is an oxide such as Fe oxide (e.g., FeO or Fe₂O₃) to a Ga₂O₃ material.
(2) The ratio of an amount of Fe incorporated into a grown crystal to an amount of Fe added to Ga₂O₃ is about 0.2. This ratio can be said to be a segregation coefficient of Fe in Ga₂O₃.
(3) It is considered that Fe exists in a Ga₂O₃ melt in the form of an oxide such as FeO. When a melt that has risen up through the slit formed approximately at the center of the die from the crucible by capillary phenomenon is crystallized right over the slit, part of the Fe oxide contained in the melt is incorporated into the crystal at a ratio of about 0.2 with respect to its addition amount and the other part of the Fe oxide remains in the melt at a ratio of about 0.8.
(4) While part of the melt that has risen up through the slit is crystallized on the crystal side, the other part flows through the gap between the crystal growth interface and the top surface of the die toward the edges of the die top surface (i.e., the ridges formed by the top surface and the side surfaces).
(5) Based on items (3) and (4), it is considered that the concentration of the Fe oxide in the melt that flows through the gap between the crystal growth interface and the die top surface toward the edges of the die top surface increases toward the edges of the die top surface.
(6) As the pulling-up of the crystal proceeds, the amount of the Fe oxide remaining in the melt existing in the gap between the crystal growth interface and the die top surface is increased and the concentration of the Fe oxide existing in melts located in the vicinities of the edges of the die top surface becomes even higher to lower the solidification temperature (melting temperature lowers).
(7) As a result of the phenomenon (6), in the melt existing in the gap between the crystal growth interface and the die top surface, the portions in the vicinities of the edges of the die top surface are crystallized less easily because the crystallization temperature (solidification temperature) of those portions where the concentration of the Fe oxide is made higher than its addition concentration is lower than in the portion right over the slit of the die where the concentration of the Fe oxide remains approximately the same as its addition concentration; thus, outer peripheries of the crystal recede from the edges of the top surface of the die. As a result, plural linear recesses are formed so as to extend in the pulling direction in an as-grown surface, extending in the crystal pulling direction, of a crystal grown.

Furthermore, the inventors confirmed that the above-described problem of formation of linear recesses in a crystal grown does not occur in a case that an Sn oxide is used as a dopant material instead of an Fe oxide to employ Sn as dopant. The reason is considered as follows. Although the concentration of the Sn oxide is made higher in the portions of a melt in the vicinities of the edges of the die top surface as in the case of use of the Fe oxide, since Sn is high in volatility in the vicinity of the melting temperature of Ga₂O₃, Sn volatilizes from the edges of the die top surface and almost no decrease occurs in the crystallization temperature (solidification temperature).

For the above reason, it is inferred that also in the case where an least one element selected from the group consisting of Mg, Si, Ti, Fe, Co, Ni, Cu, Zr, Nb, Hf, and Ta which are low in volatility in the vicinity of the melting temperature of Ga₂O₃ is used as a dopant(s), segregation of an oxide of the dopant would occur to cause the above-described problem that linear recesses are formed in a crystal grown.

Also in a case of growing a single crystal of a metal oxide other than Ga₂O₃, if a dopant is added that is low in volatility in the vicinity of the melting temperature of that metal oxide, segregation of an oxide of the dopant occurs in the same manner as in the case of using Fe in growing a Ga₂O₃ single crystal to cause the above-described problem of formation of linear recesses in a crystal grown.

How the dopant concentration and the solidification temperature of a melt vary in a process of crystal precipitation from a melt can be understood using a phase diagram.

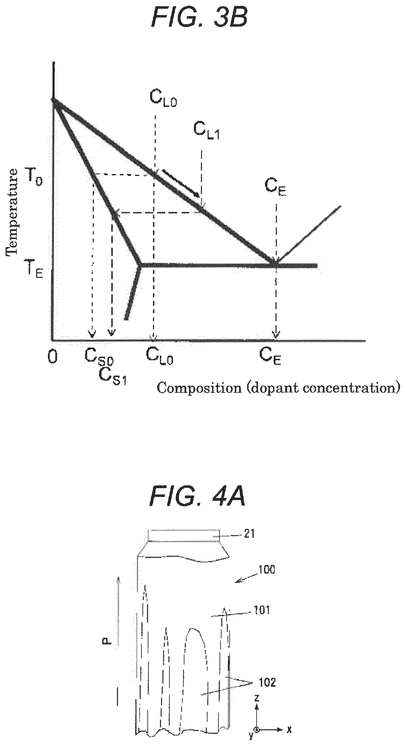

FIGs. 3A and 3B are phase diagrams each showing a relationship between the temperature of a certain pure substance and the concentration of a dopant added to that pure substance.

An addition concentration of a dopant in a melt of a pure substance is represented by C_{L0}. First, when the temperature of the melt is lowered, as shown in FIG. 3A a primary crystal having a composition on a solid phase line at a temperature To at which a liquid phase line is reached is precipitated. The addition concentration of the dopant (liquid phase composition C_{L0}) and the concentration in the primary crystal (solid phase concentration Cso) have a relationship k = C_{S0}/C_{L0} and k is called a segregation coefficient.

Where the dopant is diffused sufficiently in the liquid phase, as shown in FIG. 3B the dopant concentration in the liquid phase increases and the solidification temperature lowers along the liquid phase line as the solidification of the material proceeds. In parallel with these actions, the concentration of the dopant incorporated in the crystal increases. As the dopant concentration in the liquid phase increases from C_{L0} to C_{L1}, the concentration of the dopant incorporated in the crystal increases from C_{S0} to C_{S1}. Finally, crystallization occurs at a eutectic point in the form of a mixture at a dopant concentration C_{E}.

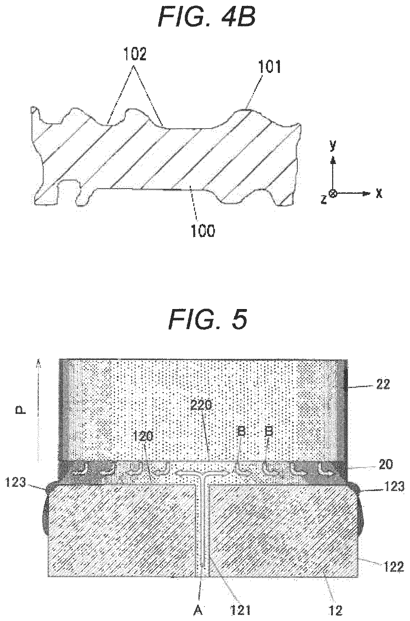

FIG. 4A shows an appearance of a single crystal ingot 100 grown by an EFG method using a conventional apparatus, as comparative example. FIG. 4B is a sectional view, taken perpendicularly to the crystal pulling direction P, of the single crystal ingot 100. The single crystal ingot 100 is an unprocessed grown crystal as pulled up, that is, an as-grown crystal.

The as-grown side surface (outer circumferential surface) 101, extending in the crystal pulling direction P, of the single crystal ingot 100 has plural linear recesses 102 extending in the crystal pulling direction P. For the above-described reason, the recesses 102 are formed after the pulling-up of the crystal has proceeded to some extent and are increased in size as the pulling-up proceeds further. Thus, the recesses 102 are increased in size as their position goes away from the seed crystal 21. Furthermore, there is a tendency that the recesses 102 start to be formed from positions near the four corners when the single crystal ingot 100 are seen from the crystal pulling direction P.

### (Manufacturing method of single crystal)

A manufacturing method of a single crystal according to the present embodiment that has been invented in view of the problem of the above-described EFG single crystal growth will be described below.

FIG. 5 is a schematic diagram showing a state in the vicinity of a crystal growth interface 220 in EFG single crystal growth using a crystal growth die 12 according to the first embodiment of the invention. In FIG. 5, the gradation that is given to each of a melt 20 and a growth crystal 22 indicates, schematically, a concentration distribution of a dopant oxide; a darker gradation portion means a higher concentration.

In the crystal growth die 12, the top surface 120 is flat and is formed with an opening of the slit 121. The top surface 120 has drainage acceleration portions 123 for accelerating drainage of a melt 20 from the top surface 120 at the edges of the top surface 120 (i.e., the ridges between the top surface 120 and side surfaces 122) or positions that are in the vicinities of the edges and are spaced from the slit 121 (i.e., not in contact with the slit 121).

As described above, the solidification temperature is low and hence the viscosity is low in portions, close to the edges of the top surface 120, of a melt 20. Thus, once a melt 20 remaining in the gap between the crystal growth interface 220 and the top surface 120 because of surface tension reaches the drainage acceleration portions 123, it flows to the side surfaces 122 past the drainage acceleration portions 123. In this manner, the drainage acceleration portions 123 can effectively urge drainage, from the top surface 120, of melts 20 that are located in the vicinities of the edges of the top surface 120 and are high in the concentration of the dopant oxide.

As shown in FIG. 1, in the EFG single crystal growing apparatus 10 according to the embodiment, flow passages of a melt 20 from the top surface 120 of the crystal growth die 12 to inside the crucible 11 are secured and hence a melt 20 drained from the top surface 120 can return to inside the crucible 11 across the side surfaces 122. As a result, a drained melt 20 can be reused for single crystal growth without being discarded uselessly.

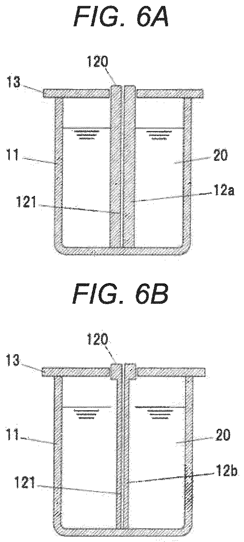

FIGs. 6A and 6B are sectional views of parts of EFG single crystal growing apparatuses 10 that employ crystal growth dies 12a and 12b that are modifications of the crystal growth die 12, respectively. In the crystal growth die 12a, each of the side surfaces is not formed with a step. In the crystal growth die 12b, a top portion including the top surface 120 is wider than the other portion. In the case where the crystal growth die 12a or 12b is used, flow passages of a melt 20 from the top surface 120 of the crystal growth die 12 to inside the crucible 11 are secured.

In the embodiment, occurrence of growth failures in the outer peripheries of a growth crystal 22 can be suppressed by growing a growth crystal 22 while portions, located in the vicinities of the edges of the top surface 120 and being high in the concentration of the dopant oxide, of a melt 20 existing between the top surface 120 of the crystal growth die 12 and the crystal growth interface 220 are drained using the drainage acceleration portions 123.

As a result, the depths of plural linear recesses that are formed in an as-grown surface, extending in the crystal pulling direction, of a grown single crystal ingot and extend in the crystal pulling direction can be made small.

The features that the top surface 120 of the crystal growth die 12 is flat and that the drainage acceleration portions 123 are provided at positions that are spaced from the slit 121 are conditions for preventing air from entering the slit 121 from the sides in the case where the slit 121 is open sideways. If air enters the slit 121 from the sides during crystal growth, a melt is not raised and no crystal grows from the portion that air entered, resulting in formation of a recess in a grown crystal 22.

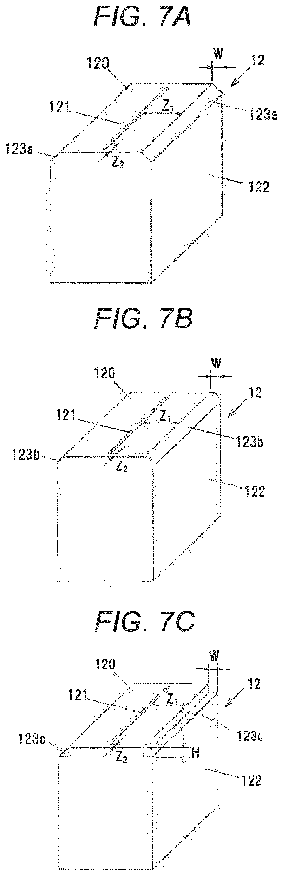

FIGs. 7A-7C are perspective views showing example structures of the drainage acceleration portions 123 of the crystal growth die 12 (12a, 12b).

Chamfered portions 123a shown in FIG. 7A, which are one form of the drainage acceleration portions 123, are slant surfaces formed by chamfering the ridges between the top surface 120 and the side surfaces 122. The manner of forming the drainage acceleration portions 123a is not limited to C chamfering (i.e., chamfering of an angle 45°).

R-chamfered portions 123b shown in FIG. 7B, which are another form of the drainage acceleration portions 123, are curved surfaces formed by R-chamfering the ridges between the top surface 120 and the side surfaces 122.

Step portions 123c shown in FIG. 7C, which are a further form of the drainage acceleration portions 123, are steps formed by working the edges of the top surface 120 into step shapes, respectively. Each of the step portions 123c may be formed by plural steps.

It is preferable that the width W of the chamfered portions 123a, the R-chamfered portions 123b, and the step portions 123c be in a range of 0.1 mm or more and 2 mm or less. Draining effect for the melt 20 is exerted effectively in the case where the width W is 0.1 mm or larger. On the other hand, draining effect for the melt 20 exhibits almost no variation after the width W exceeds 2 mm. Thus, setting width W at 2 mm or smaller makes it possible to avoid size increase of the crystal growth die 12 while sufficiently exerting draining effect for the melt 20.

To sufficiently exert draining effect for the melt 20 , it is preferable that the height H of the step portions 123c be in a range of 0.1 mm or more and 1 mm or less.

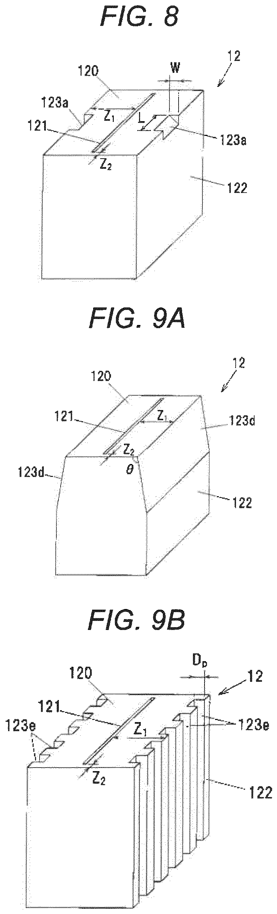

FIG. 8 is a perspective view of a crystal growth die 12 (12a, 12b) of a case that portions of the edges of the top surface 120 are formed with chamfered portions 123a, respectively. Portions of the edges of the top surface 120 may likewise be formed with R-chamfered portions 123b or step portions 123c, respectively.

In this case, it is also preferable that the width W of the chamfered portions 123a, the R-chamfered portions 123b, and the step portions 123c be in a range of 0.1 mm or more and 2 mm or less. The draining effect for the melt 20 is exerted effectively in the case where the width W is 0.1 mm or larger. Furthermore, where the width W is set smaller than or equal to 2 mm, the probability that the presence of the chamfered portions 123a, the R-chamfered portions 123b, or the step portions 123c becomes a cause of formation of recesses in an as-grown surface, extending in the crystal pulling direction P, of a grown crystal 22.

The length L of the chamfered portions 123a, the R-chamfered portions 123b, and the step portions 123c is preferably 0.1 mm or larger. The draining effect for the melt 20 is exerted effectively in the case where the length L is 0.1 mm or larger.

The draining effect for the melt 20 can be enhanced by forming chamfered portion 123a, R-chamfered portion 123b, or step portion 123c, each of which is provided at a part of the edge of the top surface 120, in plural portions in such a manner that they are arranged along the edge.

FIGs. 9A-9C are perspective views showing other example structures of the drainage acceleration portions 123 of the crystal growth die 12 (12a, 12b).

Slant portions 123d shown in FIG. 9A, which are one form of the drainage acceleration portions 123, are slant surfaces each of which is formed in all or part of an upper portion of a side surface 122. An inclination angle θ of the slant portion 123d (i.e., an angle formed by the top surface 120 and each slant portion 123d) is preferably 100° or larger. The draining effect for the melt 20 is exerted effectively in the case where the inclination angle θ is 100° or larger. On the other hand, the draining effect for the melt 20 exhibits almost no variation after the inclination angle θ exceeds 150°.

Grooves 123e shown in FIG. 9B, which are another form of the drainage acceleration portions 123, are linear grooves that are formed in the side surfaces 122 so as to extend from the top surface 120 toward the bottom of the crystal growth die 12. To enhance the draining effect for the melt 20, it is preferable that plural grooves 123e be formed along the edge of the top surface 120.

The depth Dₚ of the grooves 123e is preferably in a range of 0.1 mm or more and 2 mm or less. The draining effect for the melt 20 is exerted effectively in the case where the depth Dₚ is 0.1 mm or larger. Where the depth Dₚ is 2 mm or smaller, the probability that the presence of the grooves 123e becomes a cause of formation of recesses in an as-grown surface extending in the crystal pulling direction P of a grown crystal 22.

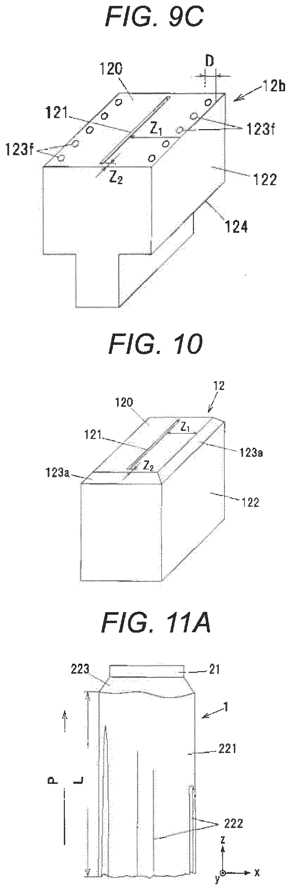

Through-holes 123f shown in FIG. 9C, which are another form of the drainage acceleration portions 123, are through-holes having respective openings in the vicinities of the edges of the top surface 120. Typically, as shown in FIG. 9C, the through-holes 123f penetrate through a wide upper portion of the crystal growth die 12b from its top surface 120 to its bottom surfaces 124. In this case, to prevent a melt 20 in the crucible 11 from rising up through the through-holes 123f by capillary phenomenon, it is necessary that the bottom surfaces 124 be spaced from the liquid surface of the melt 20 in the crucible 11. Where the through-holes 123f penetrate from the top surface 120 to the side surfaces 122, this structure can be applied to any of the crystal growth dies 12, 12a, and 12b as long as the openings in the side surfaces 122 are located above the liquid surface of the melt 20 in the crucible 11. To enhance the draining effect for the melt 20, it is preferable that plural through-holes 123f be formed alongside the edge of the top surface 120.

The diameter of the through-holes 123f is preferably in a range of 0.1 mm or more and 2 mm or less. The draining effect for the melt 20 is exerted effectively in the case where the diameter is 0.1 mm or larger. Where the diameter is 2 mm or smaller, the probability is lowered that even melt 20 that is distant from the edges of the top surface 120 to some extent and in which the concentration of the dopant oxide is relatively low is drained to impair the crystal growth.

The distance D between the portions, closest to the slit 121, of the through-holes 123f and the edges of the top surface 120 is preferably 2 mm or shorter. Where the distance D is longer than 2 mm, even melt 20 that is distant from the edges of the top surface 120 to some extent and in which the concentration of the dopant oxide is relatively low may be drained to impair the crystal growth.

Where the top surface 120 is rectangular or square, it is preferable that the above-described various kinds of drainage acceleration portions 123 be formed in the vicinities of at least ones, parallel with the slit 121, of the edges of the top surface 120 as shown in FIGs. 7A-7C, 8, and 9A-9C. This is to effectively drain, by means of the drainage acceleration portions 123, melt 20 that is distant to a large extent from the edges parallel with the slit 121 and has high concentration of the dopant oxide in the vicinities of edges parallel with the slit 121.

To effectively drain melt 20 that is high in the concentration of the dopant oxide and thereby effectively decrease the depths of recesses formed in an as-grown surface, parallel with the crystal pulling direction P, of a grown crystal 22, it is preferable that the drainage acceleration portions 123 be formed in the vicinities of all of the edges of the top surface 120.

FIG. 10 is a perspective view of a crystal growth die 12 in which all of the edges of the top surface 120 are formed with chamfered portions 123a, respectively. It is preferable that an R-chamfered portion 123b, a step portion 123c, a slant portion 123d, grooves 123e, and through-holes 123f be likewise formed at or in the vicinity of every edge of the top surface 120.

The shape of the top surface 120 of the crystal growth die 12 is not limited to a rectangle and a square and may be a circle, for example.

### (Features of single crystal)

FIG. 11A shows an appearance of a single crystal ingot 1 according to the first embodiment of the invention. The single crystal ingot 1 is an unprocessed grown crystal 22 that is left as it is after it was pulled up, that is, an as-grown crystal 22. Thus, the single crystal ingot 1 is, for example, a single crystal ingot of a Ga₂O₃-based compound and contains, as a dopant(s), one or more elements selected from the group consisting of Mg, Si, Ti, Fe, Co., Ni, Cu, Zr, Nb, Hf, and Ta which are low in volatility in the vicinity of the melting temperature of Ga₂O₃.

A side surface (outer circumferential surface) 221 extending in the longitudinal direction that is parallel with the crystal pulling direction P is an as-grown surface, and the length L of a portion, surrounded by the side surface 221, of the single crystal ingot 1 (i.e., a portion excluding a shoulder portion that is formed in a growth initial stage) is 50 mm or longer. Where the length L is 50 mm or longer, substrates of about 2 inches in diameter can be cut out from the single crystal ingot 1 by, for example, setting the width of the single crystal ingot 1 (i.e., the length of the sides that are perpendicular to the length L direction and are not in the width direction of the slit 121 of the die 12) 50 mm or longer at any position. The length L and the width of the single crystal ingot 1 are preferably 60 mm or longer, even preferably 70 mm or longer.

The thickness of the single crystal ingot 1 (i.e., the length of the sides that are in the width direction of the slit 121 during crystal growth) is preferably 10 mm or longer at any position. It is even preferable that the thickness of the single crystal ingot 1 be 15 mm or longer. Where the grown crystal 22 is too thin, there may occur a phenomenon that the grown crystal 22 becomes insufficient for a pulling-up speed and the crystal being grown is separated from the crystal growth die 12 and the crystal growth is stopped.

The phenomenon that the grown crystal 22 is detached from the crystal growth die 12 in the case where the single crystal ingot 1 is thin is considered due to the following reason. (1) The horizontal gradient of the concentration of the dopant oxide tends to remain small in a melt 20 located between the top surface 120 of the crystal growth die 12 and the crystal growth interface 220 and the concentration of the dopant oxide increases in the entire area as the growth proceeds. Thus, the melting temperature lowers in the entire melt 20 located between the top surface 120 of the crystal growth die 12 and the crystal growth interface 220, making it difficult to maintain the crystal growth. (2) When the concentration of the dopant oxide is increased, the melt 20 located between the top surface 120 of the crystal growth die 12 and the crystal growth interface 220 comes to have a eutectic composition (for example, to obtain, as a single crystal ingot 1, an ingot of a Ga₂O₃ single crystal containing Fe as a dopant, a melt 20 becomes a Ga₂O₃/Fe₂O₃-based stoichiometric compound rather than Ga₂O₃ containing Fe.

The single crystal ingot 1 has plural linear recesses 222 that are formed in the portion surrounded by the side surface 221 so as to extend in the longitudinal direction. The recesses 222 become larger as the position goes away from the seed crystal 21. That is, the recesses 222 are formed in the portion surrounded by the side surface 221 so as to start from one end opposite to the seed crystal 21 and extend in the longitudinal direction, that is, the crystal pulling direction.

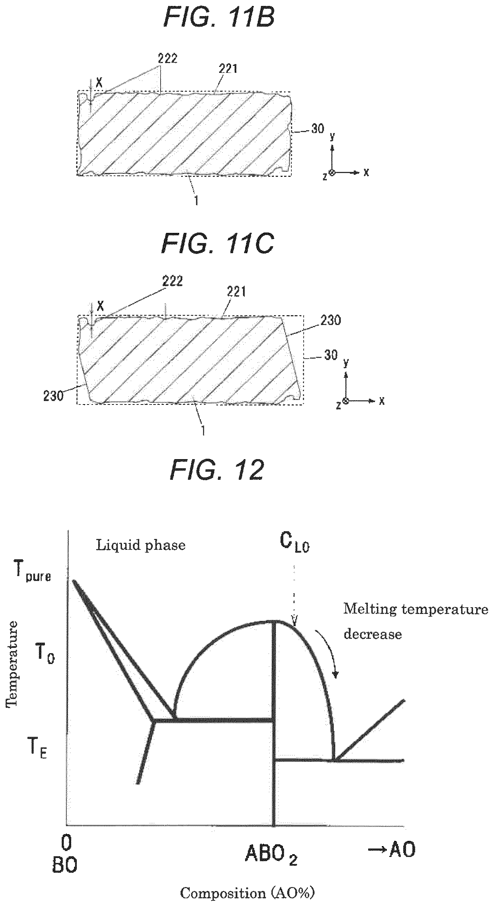

FIGs. 11B and 11C are example cross sections, taken perpendicularly to the longitudinal direction at a position that is distant from the other end located on the side without recesses 222 in the longitudinal direction (i.e., the end on seed crystal 21 side) by 50 mm in the longitudinal direction, of the portion, surrounded by the side surface 221, of the single crystal ingot 1. FIG. 11B shows an example cross section of a case that the single crystal ingot 1 has no facet and FIG. 11C shows an example cross section of a case that the single crystal ingot 1 has facets 230. The term "facet" means a flat surface that appears as a surface of a crystal that has experienced facet growth. Also in the EFG method, a facet 230 may appear as a result of facet growth that has occurred in a surface surrounded by a side surface 221 depending on factors such as the concentration of a dopant oxide in a melt 20, increase of the concentration of the dopant oxide that occurs as the growth proceeds, and the temperature conditions described above. A portion that is defined by an intersection line formed by a facet 230 and a cross section deviates inward from an ideal external shape 30 but can be discriminated because it is a flat line unlike in a case of a recess 222.

As for the external shape of a cross section as shown in FIG. 11B or 11C taken at a position that is distant from the other end of a single crystal ingot 1 by 50 mm in the longitudinal direction, it is preferable that the maximum value (hereinafter represented by Xₘₐₓ) of distances X of recesses 222 from an ideal external shape 30 in portions other than portions formed by intersection lines of the cross section and facets 230 be 5 mm or smaller, even preferably 4 mm or smaller and further preferably 3 mm or smaller. Furthermore, as for the external shape of a cross section taken at a position that is distant from the other end of the single crystal ingot 1 by 80 mm in the longitudinal direction, it is preferable that the distances Xₘₐₓ of recesses 222 from an ideal external shape 30 be 5 mm or smaller. In the case of single crystal ingots 100 grown by an EFG method using a conventional apparatus, Xₘₐₓ does not become 5 mm or smaller. If Xₘₐₓ is small, in the case where the width of a single crystal ingot 1 is, for example, 50 mm or larger, a large number of substrates can be cut out because recesses 222 are small in a region of the single crystal ingot 1 from which substrates of about 2 inches in diameter can be cut out.

The term "ideal external shape 30" as used above is a rectangle or quadrangle having a smallest area that can contain the external shape of a cross section taken at a position that is distant from the above-mentioned other end located on the side without recesses 222 by 50 mm in the longitudinal direction. The ideal external shape 30 of a single crystal ingot 1 is approximately the same as the external shape of the top surface 120 of the crystal growth die 12. The ideal external shape 30 is a rectangle in the case where the top surface 120 is a rectangle, and is approximately a square in the case where the top surface 120 is a square.

In the case of single crystal ingots 100 containing a dopant and grown by an EFG method using a conventional apparatus, Xₘₐₓ does not become 5 mm or smaller. Xₘₐₓ may become smaller if a single crystal ingot 100 is made thinner. However, if a single crystal ingot 100 is made thinner, it is highly probable that a grown crystal 212 becomes insufficient for a pulling-up speed during crystal growth and is separated from a crystal growth die 200 and the crystal growth is stopped before Xₘₐₓ reaches 5 mm.

In single crystal ingots 100 containing a dopant and grown by an EFG method using a conventional apparatus, there may occur a case that an ideal external shape 30 does not coincide with the external shape of the top surface of a crystal growth die because large recesses 102 are formed over the entire circumference. Also in that case, the maximum value Xₘₐₓ of distances X from an ideal external shape 30 in portions other than portions formed by intersection lines of a cross section of single crystal ingot 100 and facets does not become 5 mm or smaller. This is because recesses 102 are not formed uniformly over the entire circumference of the crystal.

Even if it is grown by an EFG method using a conventional apparatus, a single crystal ingot not containing a dopant does not have recesses in a side surface and hence a cross section taken perpendicularly to the crystal pulling direction has an external shape that is approximately coincide with the external shape of the top surface of the crystal growth die.

In the above-described manufacturing method of a single crystal according to the embodiment, the sizes of recesses 222 formed in a single crystal ingot 1 can be reduced. On the other hand, even where the method according to the embodiment is used, the distance Xₘₐₓ seldom becomes smaller than 1 mm. Thus, in many cases, the distance Xₘₐₓ is 1 mm or larger.

When the dopant concentration is high, crystal growth may become close to solution growth rather than melt growth and a facet(s) 230 may appear as described above. Since formation of a facet(s) 230 is also a cause of making the sectional area of a single crystal ingot 1 small, it is preferable that the external shape of a cross section taken perpendicularly to the longitudinal direction at a position that is distant from the other end located on the side without recesses 222 in the longitudinal direction by 50 mm in the longitudinal direction be such that the maximum value Xₘₐₓ of distances X of recesses 222 from an ideal external shape 30 of all portions including a portion(s) formed by an intersection line of the cross section and a facet(s) 230 be 5 mm or smaller, even preferably 4 mm or smaller and further preferably 3 mm or smaller. According to the above-described manufacturing method of a single crystal according to the embodiment, formation of facets 230 can be suppressed because a crystal can be grown while draining melts 20 that are located in the vicinities of the edges of the top surface 120 of the crystal growth die 12 and in which the concentration of the dopant oxide is high.

Furthermore, according to the above-described manufacturing method of a single crystal according to the embodiment, by reducing the sizes of recesses 222, the area of a cross section, taken perpendicularly to the longitudinal direction at a position that is distant from the end located on the side without recesses 222 in the longitudinal direction (i.e., the end on the seed crystal 21 side) by 50 mm in the longitudinal direction, of a portion, surrounded by a side surface 221, of a single crystal ingot 1 can be made 80% or more of the area of the top surface 120 of the crystal growth die 12, preferably 90% or more.

As described above, the concentration of the dopant oxide in melts 20 located between the crystal growth interface 220 and the top surface 120 of the crystal growth die 12 increases as the position goes away from the slit 121. For this reason, where the distance Z₁ between the edges of the top surface 120 and the slit 121 in the slit width direction (refer to FIGs. 7-10) is longer than the distance Z₂ between the edges of the top surface 120 and the slit 121 in the slit direction (refer to FIGs. 7-10), the concentration of the dopant oxide in melts 20 located in the vicinities of the edges of the top surface 120 in the slit width direction is higher. As a result, in this case, the maximum concentration of the dopant oxide in melts 20 located in the vicinities of the edges of the top surface 120 become higher and the maximum depth (i.e., the length of the longest one of lines drawn perpendicularly to the sides of plural recesses 222 from the sides of an ideal external shape) of the recesses 222 becomes larger as the maximum value (called a "distance Z") of the distance Z₁ increases. That is, there exists a correlation between the distance Z and the depth of recesses 222. According to the above-described manufacturing method of a single crystal according to the embodiment, the maximum depth of recesses 222 at a position that is distant from the end located on the side without recesses 222 in the longitudinal direction (i.e., the end on the seed crystal 21 side) by 50 mm in the longitudinal direction, of a portion, surrounded by a side surface 221, of a single crystal ingot 1 can be made as small as Z × 0.3 or less.

Furthermore, as described above, a single crystal ingot 1 having recesses 222 contains a dopant that is low in volatility in the vicinity of a melting point of a metal oxide as a base material. For example, where the metal oxide is a Ga₂O₃-based semiconductor, it contains, as a dopant(s), one or more elements selected from the group consisting of Mg, Si, Ti, Fe, Co, Ni, Cu, Zr, Nb, Hf, and Ta.

There are no particular limitations on the concentration of the dopant of a single crystal ingot 1. This is because even if the concentration of the dopant of a single crystal ingot 1 (i.e., a dopant concentration in a central portion) is on the ppm order, during crystal growth the dopant concentration of melts 20 in the vicinities of the edges of the top surface 120 of the crystal growth die 12 is increased to such a level that recesses 222 can be formed. That is, recesses 222 can be formed even if a dopant material that is low in volatility in the vicinity of the melting temperature of a metal oxide as a base material is contained in a melt 20 by even a very small amount. In the case of a single crystal ingot 1 that is an ingot of a semi-insulative Ga₂O₃ single crystal containing Fe, a typical Fe concentration is 15 to 30 ppm (weight) and a concentration of FeO in a melt 20 needs to be 100 to 200 ppm (weight) if segregation is taken into consideration. However, recesses 222 are formed even at a lower concentration than this range.

### (Second embodiment)

Although the first embodiment was directed to the case of growing a single crystal containing a dopant that is low in volatility in the vicinity of the melting temperature of a metal oxide as a base material, the problem of formation of recesses 222 may occur in the same mechanism also in growing a single crystal of a pseudobinary-component compound such as a composite oxide.

Example pseudobinary-component compounds such as a composite oxide are LiNbO₃ which is considered a composite of two kinds of metal oxides Li₂O and Nb₂O₅, Y₃Al₅O₁₂, and PbMoO₄.

If a slight deviation occurs in the material composition of a pseudobinary-component compound such as a composite oxide, a difference occurs between a crystallization composition and a composition in the vicinity of a crystal interface, as a result of which the solidification temperature of melts 20 located in the vicinities of the edges of the top surface 120 of the crystal growth die 12 lowers as in the case of segregation of a dopant oxide. A case of growing a single crystal of a composite oxide ABO₂ will be described below.

FIG. 12 is a phase diagram showing a relationship between the temperature and the composition of a composite oxide including an AO component and a BO component. Assume that the amount of the AO component in a melt is C_{L0} that is slightly deviated from its amount in ABO₂. In this case, as shown in FIG. 12, as crystal growth proceeds, the deviation in composition increases to cause melting temperature reduction (solidification temperature reduction).

That is, if the material composition of a pseudobinary-component compound such as a composite oxide has a slight deviation, the deviation of the composition of a melt increases and the solidification temperature lowers as the position goes from right over the slit 121 toward each edge on the top surface 120 of the crystal growth die 12.

According to the manufacturing method of a single crystal according to the first embodiment of the invention, a crystal can be grown while draining melts 20 in the vicinities of the edges of the top surface 120 of the crystal growth die 12. Thus, if this method is applied to this embodiment in which a single crystal of a pseudobinary-component compound such as a composite oxide is grown, a crystal can be grown while draining melts 20 that are located in the vicinities of the edges of the top surface 120 and hence have a large deviation in composition and are lowered in solidification temperature. The sizes of recesses 222 can therefore be made small.

### (Advantage of embodiments)

The above embodiments can provide an EFG manufacturing method of a single crystal capable of decreasing the depths of the recesses even in a case that recesses are formed in an as-grown surface, extending in a crystal pulling direction, of a single crystal grown, a crystal growth die to be used in that manufacturing method, and a single crystal ingot manufactured by that manufacturing method.

### EXAMPLE

A Ga₂O₃ single crystal containing Fe as a dopant was grown by a conventional EFG method and a distribution of Fe concentration in the single crystal was measured by a laser abrasion ICP-MS method.

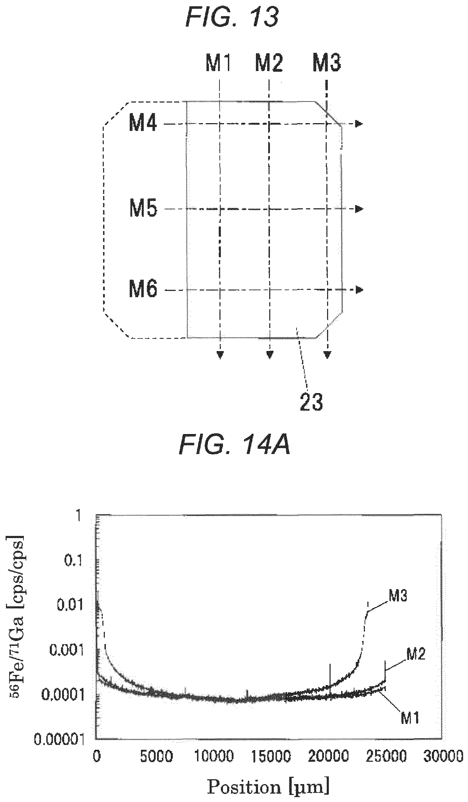

FIG. 13 is a plan view showing a plate member 23 measuring 25 mm × 15 mm that was cut out from a Ga₂O₃ single crystal ingot by cutting it perpendicularly to a crystal pulling direction and measurement positions (M1-M6) of the concentration measurement.

The Ga₂O₃ single crystal plate member shown in FIG. 13 was cut out from a region (indicated by a broken line in FIG. 13), obtained by removing recesses 222, of the Ga₂O₃ single crystal ingot whose cross section taken perpendicularly to the crystal pulling direction measured 30 mm × 30 mm. The surfaces of the Ga₂O₃ single crystal plate member were polished and a distribution of Fe concentration was measured.

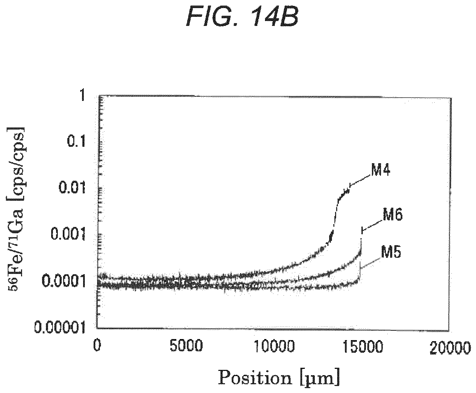

FIGs. 14A and 14B are graphs showing a distribution of Fe concentration of the measured Ga₂O₃ single crystal plate member. Numbers (M1-M6) of respective data shown in FIGs. 14A and 14B correspond to the numbers (M1-M6) of measurement positions shown in FIG. 13. The horizontal axis of FIGs. 14A and 14B represent the position with respect to a measurement start position and the vertical axis represents the ratio of the intensity of ⁵⁶Fe with respect to that of ⁷¹Ga in a mass spectrometry signal.

As seen from FIGs. 14A and 14B, the Fe concentration of the Ga₂O₃ single crystal plate member increases toward the outer peripheries of the Ga₂O₃ single crystal plate member and, in particular, increases rapidly in the vicinities of the outer peripheries. This indicates a probability that the concentration of Fe in a melt located between the top surface of a crystal growth die and a crystal growth interface increases rapidly as the position comes closer to the edges of the top surface of the die, which causes reduction of the solidification temperature.

Furthermore, according to observations of the present inventors, after the crystal growth residues of a high-concentration Fe oxide were found in portions of the top surface of the die where the crystal side surface receded (i.e., portions where recesses occurred). Also based on this finding, it is inferred that the expansion of a crystal to the edges of the crystal growth die was obstructed as a result of increase of the Fe concentration in the vicinities of the edges of the crystal growth die and the solidification temperature lowered there.

Although the embodiments and Example according to the invention have been described above, the invention is not limited to these embodiments and Example and various modifications are possible without departing from the gist and scope of the invention.

The above-described embodiments and Example should not be construed as restricting the claimed invention. Furthermore, it should be noted that all of the combination of the features described in the embodiments and Example is not necessarily indispensable for the means for attaining the object of the invention.

### INDUSTRIAL APPLICABILITY

The present invention provides a manufacturing method, using an EFG method, of a single crystal capable of decreasing the depths of the recesses even in a case that a dopant is added that induces formation of recesses in an as-grown surface, extending in a crystal pulling direction, of a single crystal grown, a crystal growth die to be used in that manufacturing method, and a single crystal ingot manufactured by that manufacturing method.

### DESCRIPTION OF SYMBOLS

1: Single crystal ingot
10: EFG single crystal growing apparatus
12: Crystal growth die
20: Melt
22: Grown crystal
30: Ideal external shape
120: Top surface
121: Slit
122: Side surface
123: Drainage acceleration portion
123 a: Chamfered portion
123b: R-chamfered portion
123c: Step portion
123d: Slant portion
123e: Groove
123f: Through-hole
220: Crystal growth interface
221: Side surface
222: Recess

## Claims

1. An as-grown single crystal ingot of a metal oxide containing a dopant or a pseudobinary-component compound, wherein:
a length of a side surface, extending in a longitudinal direction that is parallel with a crystal pulling direction, in the longitudinal direction is 50 mm or larger;
the side surface has a linear recess that extends in the longitudinal direction from one end in the longitudinal direction;
among cross sections taken perpendicularly to the longitudinal direction of a portion surrounded by the side surface, a cross section at a position that is distant from the other end located on a side without the recess in the longitudinal direction by 50 mm in the longitudinal direction has an external shape such that a distance Xₘₐₓ that is a maximum value of distance of the recess from an ideal external shape is 5 mm or shorter in portions excluding a portion formed by an intersection line of the cross section and a facet; and
the ideal external shape is a rectangle or a quadrangle having a smallest area capable of containing the external shape of the cross section.

2. The single crystal ingot according to claim 1, wherein a width of the single crystal ingot is 50 mm or larger.

3. The single crystal ingot according to claim 1 or 2, wherein the distance Xₘₐₓ that is a maximum value of distance of the recess from the ideal external shape is 5 mm or shorter in all portions including the portion formed by the intersection line of the cross section and the facet.

4. The single crystal ingot according to any one of claims 1 to 3, wherein:
the metal oxide is a Ga₂O₃-based semiconductor; and
the dopant is one or more elements selected from the group consisting of Mg, Si, Ti, Fe, Co, Ni, Cu, Zr, Nb, Hf, and Ta.

5. The single crystal ingot according to any one of claims 1 to 4, wherein the distance Xₘₐₓ is 1 mm or longer.

6. A crystal growth die to be used for crystal growth using an EFG method, the crystal growth die comprising:
a top surface having an opening of a slit and being flat; and
a drainage acceleration portion for urging drainage of a melt from the top surface, that is formed at an edge of the top surface or a position that is located in a vicinity of the edge and spaced from the slit.

7. The crystal growth die according to claim 6, wherein the drainage acceleration portion is formed at least in a vicinity of the edge that is parallel with the slit.

8. The crystal growth die according to claim 6 or 7, wherein the drainage acceleration portion is a chamfered portion, an R-chamfered portion, or a step portion that is formed in at least a part of the edge.

9. The crystal growth die according to claim 6 or 7, wherein the drainage acceleration portion is a slant portion that is formed in entire or a part of an upper portion of a side surface.

10. The crystal growth die according to claim 6 or 7, wherein the drainage acceleration portion is a groove that is formed in a side surface so as to extend downward from the top surface.

11. The crystal growth die according to claim 6 or 7, wherein the drainage acceleration portion is a through-hole having an opening in a region located in a vicinity of the edge of the top surface.

12. A manufacturing method, using an EFG method, of a single crystal of a metal oxide containing a dopant or a pseudobinary-component compound, wherein:
the single crystal is pulled up while a melt located between a top surface of a crystal growth die and a single crystal growth interface is drained from an edge of the top surface of the crystal growth die or a portion in a vicinity of the edge.

13. A manufacturing method, using an EFG method, of a single crystal of a metal oxide containing a dopant or a pseudobinary-component compound, wherein:
a linear recess is formed in a side surface extending in a longitudinal direction that is parallel with a crystal pulling direction of the single crystal when the single crystal is pulled up; and
in an ingot of the single crystal grown, among cross sections taken perpendicularly to the longitudinal direction of a portion surrounded by the side surface, a cross section at a position that is distant from an end located on a side without the recess in the longitudinal direction by 50 mm in the longitudinal direction has an area of 80% or more of an area of the top surface of a crystal growth die.

14. The manufacturing method of a single crystal according to claim 12 or 13, wherein:
the metal oxide is a Ga₂O₃-based semiconductor; and
the dopant is one or more elements selected from the group consisting of Mg, Si, Ti, Fe, Co, Ni, Cu, Zr, Nb, Hf, and Ta.

15. The manufacturing method of a single crystal according to any one of claims 12 to 14, wherein the crystal growth die according to any one of claims 6 to 11 is used.
